# EUROPEAN PATENT APPLICATION

(11) **EP 4 383 356 A1**
(43) Date of publication of application: **12.06.2024**
(21) Application number: 23164409.7
(22) Date of filing: 27.03.2023
(51) Int. Cl.: H01L 31/0747, H01L 31/18, H01L 31/0236, H01L 31/0224

(54) **SOLAR CELL AND PHOTOVOLTAIC MODULE**

(30) Priority: 07.12.2022 CN 202211587601
(71) Applicant: Zhejiang Jinko Solar Co., Ltd., Haining, Zhejiang 314416 (CN); JINKO SOLAR CO., LTD, ShangRao, Jiangxi 334100 (CN)
(72) Inventor: WANG, Zhao, Haining, 314416 (CN); YANG, Jie, Haining, 314416 (CN); ZHENG, Peiting, Haining, 314416 (CN); CHEN, Jinjin, Haining,, 314416 (CN); FANG, Lingxin, Haining, 314416 (CN)
(74) Representative: Balder IP Law, S.L.

(57) **Abstract**

Disclosed are a solar cell and a photovoltaic module. The solar cell includes a substrate (100), having a first surface and a second surface opposite to the first surface. The first surface includes a metal pattern region (10) and a non-metal pattern region (11). The first surface is uneven and has a first maximum height with respect to the second surface in the non-metal pattern region (11) and a second maximum height with respect to the second surface in the metal pattern region (10), and the first maximum height is lower than the second maximum height. The solar cell includes at least one passivation contact structure (110, 20, 30), covered on the first surface and including a tunneling layer (111, 21, 31) and a doped conductive layer (112, 22, 32) stacked in a direction away from the substrate (100).

## Description

### TECHNIC FIELD

The various embodiments of the present disclosure relate to the field of solar cells, and in particular to a solar cell and a photovoltaic module.

### BACKGROUND

Solar cells have excellent photoelectric conversion capability. In a tunnel oxide passivated contact (TOPCON) cell, a tunneling oxide layer and a doped conductive layer are prepared on one surface of a substrate to suppress carrier recombination at the surface of the substrate in the solar cell and enhance the passivation effect on the substrate. The tunneling oxide layer has good chemical passivation effect and the doped conductive layer has good field passivation effect. The tunneling oxide layer further provides a tunneling channel for the carriers which tunnels through the tunneling oxide layer to the substrate, achieving selective transport of the carriers and improving a fill factor of the solar cell. In this way, good photoelectric conversion performance of the solar cell can be realized.

However, the existing solar cells have the problem of low photoelectric conversion efficiency.

### SUMMARY

According to embodiments of the present disclosure, a solar cell and a photovoltaic module are provided, to at least contribute to improve the photoelectric conversion efficiency of the solar cell.

Some embodiments of the present disclosure provide a solar cell. The solar cell includes a substrate, having a first surface and a second surface opposite to the first surface. The first surface includes a metal pattern region and a non-metal pattern region. The first surface is uneven and has a first maximum height with respect to the second surface in the non-metal pattern region and a second maximum height with respect to the second surface in the metal pattern region, and the first maximum height is lower than the second maximum height. The solar cell includes at least one passivation contact structure, covering the first surface, and including a tunneling layer and a doped conductive layer stacked in a direction away from the substrate.

In some embodiments, a height difference between the first maximum height and the second maximum height is in a range of 0.2µm to 10µm.

In some embodiments, the first surface has a first texture structure in the metal pattern region and a second texture structure in the non-metal pattern region, and a roughness of the first texture structure is greater than a roughness of the second texture structure.

In some embodiments, the first texture structure includes a pyramid structure; the second texture structure includes a platform embossed structure, a height of the pyramid structure is greater than a height of the platform embossed structure, and a one-dimensional size of a bottom surface of the pyramid structure is less than a one-dimensional size of a bottom surface of the platform embossed structure. The height of the pyramid structure is a height from a tip of the pyramid structure to a bottom of the pyramid structure and the height of the platform embossed structure is a height from a bottom of the platform embossed structure to a top surface of the platform embossed structure.

In some embodiments, the height of the pyramid structure is in a range of 0.1µ to 5µm, and the one-dimensional size of the bottom surface of the pyramid structure is in a range of 0.01µm to 6µm.

In some embodiments, the height of the platform embossed structure is in a range of 0.002µm to 1µm, and the one-dimensional size of the bottom surface of the platform embossed structure is in a range of 0.01µm to 1000µm.

In some embodiments, the first surface further includes a transitional region adjacent to the metal pattern region and the non-metal pattern region. The transitional region has a height not lower than the first maximum height and not higher than the second maximum height, the height of the transitional region is a height at any point of the transitional region and relative to the second surface and the at least one passivation contact structure is covered on the transitional region.

In some embodiments, there is an included angle in a range of 90° to 160° between the transitional region and the non-metal pattern region.

In some embodiments, the first surface has a third texture structure in the transitional region and the third texture structure has a roughness less than the roughness of the first texture structure.

In some embodiments, the third texture structure includes a plurality of triangular-prism-shaped embossed structures adjacent to each other, and each of the plurality of triangular-prism-shaped embossed structures has a sectional shape of triangular or triangle-like in a direction perpendicular to the transitional region.

In some embodiments, the at least one passivation contact structure includes a first passivation contact structure, over the metal pattern region. The first passivation contact structure includes a first tunneling layer and a first doped conductive layer stacked in the direction away from the substrate. The at least one passivation contact structure includes a second passivation contact structure, including first portion and second portion adjacent to each other. The first portion covers a top surface and side surfaces of the first passivation contact structure, and the second portion covers the remaining region of the first surface other than the metal pattern region. The second passivation contact structure includes a second tunneling layer and a second doped conductive layer stacked in the direction away from the substrate.

In some embodiments, the first passivation contact structure includes a plurality of sub-first passivation contact structures sequentially stacked in the direction away from the substrate, and each of the plurality of sub-first passivation contact structures includes a first tunneling sub-layer and a first doped conductive sub-layer sequentially stacked in the direction away from the substrate.

In some embodiments, the second passivation contact structure includes a plurality of sub-second passivation contact structures sequentially stacked in the direction away from the substrate, and each of the plurality of sub-second passivation contact structures includes a second tunneling sub-layer and a second doped conductive sub-layer sequentially stacked in the direction away from the substrate.

In some embodiments, the first passivation contact structure includes a plurality of sub-first passivation contact structures sequentially stacked in the direction away from the substrate, and each of the plurality of sub-first passivation contact structures includes a first tunneling sub-layer and a first doped conductive sub-layer sequentially stacked in the direction away from the substrate. The second passivation contact structure includes a plurality of sub-second passivation contact structures sequentially stacked in the direction away from the substrate, and each of the plurality of sub-second passivation contact structures includes a second tunneling sub-layer and a second doped conductive sub-layer sequentially stacked in the direction away from the substrate. The plurality of sub-first passivation contact structures and the plurality of sub-second passivation contact structures are alternately stacked in the direction away from the substrate.

In some embodiments, the solar cell further includes a first electrode, which is electrically connected with the first doped conductive layer.

In some embodiments, a concentration of a doped element in the first doped conductive layer is greater than or equal to a concentration of a doped element in the second doped conductive layer.

In some embodiments, a thickness of the first doped conductive layer is greater than or equal to a thickness of the second doped conductive layer.

In some embodiments, a material of the first doped conductive layer includes at least one of amorphous silicon, polycrystalline silicon and silicon carbide, and a material of the second doped conductive layer includes at least one of amorphous silicon, polycrystalline silicon and silicon carbide.

In some embodiments, a thickness of the first tunneling layer is less than or equal to a thickness of the second tunneling layer.

In some embodiments, a material of the first tunneling layer is different from a material of the second tunneling layer.

In some embodiments, the material of the first tunneling layer includes at least one of silicon oxide, aluminum oxide, silicon nitride, silicon oxynitride, amorphous silicon, or polycrystalline silicon; the material of the second tunneling layer includes at least one of silicon oxide, aluminum oxide, silicon nitride, silicon oxynitride, amorphous silicon, or polycrystalline silicon.

Some embodiments of the present disclosure provide a photovoltaic module, including a plurality of cell strings, each formed by connecting a plurality of solar cells. Each of the plurality of solar cells is the solar cell as mentioned above. The photovoltaic module includes encapsulation layers, configured to cover surfaces of the plurality of cell strings, and cover plates, configured to cover surfaces of the encapsulation layers away from the plurality of cell strings.

The technical solutions provided by the embodiments of the present disclosure at least have the following advantages.

In the technical solutions of the solar cell provided by the embodiments of the present disclosure, the first surface is disposed to be lower in height at non-metal pattern region than that at the metal pattern region, that is, the substrate surface in the non-metal pattern region and the substrate surface in the metal pattern region form a step structure. Compared with the substrate surface which is a smooth surface, the step structure can increase a surface area of the first surface of the substrate, so as to increase a contact area of the passivation contact structure with the first surface of the substrate. In this way, in a case of keeping the passivation contract structure over the non-metal pattern region relatively smooth, a tunneling channel for the carriers can be enlarged and the tunneling efficiency of the carriers can thus be increased. In addition, since the step structure is disposed at a junction between the metal pattern region and the non-metal pattern region, the area of the passivation contact structure covered on the junction can be increased. Further, since the junction is adjacent to the metal pattern region, the carriers in the passivation contact structure at the junction can be transported to the passivation contact structure over the metal pattern region over a shorter distance, contributing to increase the collection capability for the carriers.

### BRIEF DESCRIPTION OF THE DRAWINGS

One or more embodiments are illustrated in combination with corresponding drawings. These illustrative descriptions do not constitute any limitation to the embodiments. The figures in the drawings do not constitute scale limitation unless otherwise indicated.
FIG. 1 is a schematic diagram illustrating a sectional structure of a first type of solar cell according to an embodiment of the present disclosure.
FIG. 2 is an enlarged local view of a dotted line box denoted as 1 in FIG. 1.
FIG. 3 is a local scanning electron microscope diagram illustrating a first surface of a solar cell according to an embodiment of the present disclosure.
FIG. 4 is a schematic diagram illustrating a sectional structure of a second type of solar cell according to an embodiment of the present disclosure.
FIG. 5 is a scanning electron microscope diagram illustrating a transitional region of a solar cell according to an embodiment of the present disclosure.
FIG. 6 is a schematic diagram illustrating a sectional structure of a third type of solar cell according to an embodiment of the present disclosure.
FIG. 7 is a schematic diagram illustrating a sectional structure of a fourth type of solar cell according to an embodiment of the present disclosure.
FIG. 8 is a schematic diagram illustrating a sectional structure of a fifth type of solar cell according to an embodiment of the present disclosure.
FIG. 9 is a schematic diagram illustrating a sectional structure of a sixth type of solar cell according to an embodiment of the present disclosure.
FIG. 10 is a structural schematic diagram illustrating a photovoltaic module according to another embodiment of the present disclosure.

### DETAILED DESCRIPTION OF THE EMBODIMENTS

As mentioned in the background, the existing solar cells have the problem of low photoelectric conversion efficiency.

Analysis shows that one of the reasons for the low photoelectric conversion efficiency of the existing solar cells is that: a substrate has a metal pattern region and a non-metal pattern region; for a substrate surface of the metal pattern region, a roughness is to be increased so as to increase a contact area between a metal electrode and a doped conductive layer, whereas for a substrate surface of the non-metal pattern region, a roughness is to be reduced so as to increase a smoothness of a contact interface between the passivation contact structure and the substrate, contributing to improve a passivation performance of the passivation contact structure. The carriers in the substrate are tunneled to the doped conductive layer via the tunneling layer in the passivation contact structure, and then transported through the doped conductive layer to the metal electrode for collection. When the area of the tunneling layer is larger, a larger tunneling channel can be provided for the tunneling of the carriers, so as to increase the tunneling efficiency of the carriers. But, since the substrate surface of the non-metal pattern region is set smoothed, the roughness of the substrate surface of the non-metal pattern region is smaller, such that the surface area of the substrate surface of the non-metal pattern region is made smaller, thereby decreasing the area of the tunneling layer on the substrate surface of the non-metal pattern region, and resulting in that the carrier transport efficiency cannot be further improved.

An embodiment of the present disclosure provides a solar cell. In the solar cell, a non-metal pattern region of a first surface is disposed to be lower than a metal pattern region of the first surface, that is, the non-metal pattern region and the metal pattern region of the first surface form an uneven step structure. Compared with a substrate which has a smooth surface, the step structure can increase a surface area of the first surface of the substrate, so as to increase a surface area of the passivation contact structure covered on the first surface of the substrate. In this way, in a case of keeping the passivation contract structure over the non-metal pattern region relatively smooth, a tunneling channel for the carriers is enlarged and the tunneling efficiency of the carriers is thus increased.

Detailed descriptions will be made below to the embodiments of the present disclosure in combination with accompanying drawings. However, persons of ordinary skill in the art may understand, in the embodiments of the present disclosure, many technical details are proposed to help readers to better understand the present disclosure. Without these technical details and various changes and modifications based on the following embodiments, the technical solutions claimed by the present disclosure can still be implemented.

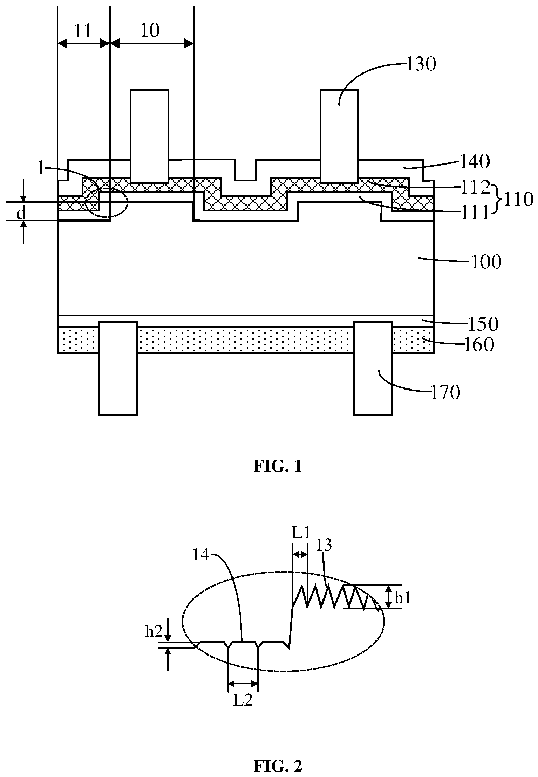

FIG. 1 is a schematic diagram illustrating a sectional structure of a first type of solar cell according to an embodiment of the present disclosure.

By referring to FIG. 1, the solar cell includes a substrate 100. The substrate has a first surface. The first surface includes a metal pattern region 10 and a non-metal pattern region 11 which are arranged in a spacing. The first surface has a height in the non-metal pattern region 11 lower than a height in the metal pattern region 10. The solar cell includes a passivation contact structure 110, covered on the first surface. The passivation contact structure 110 includes a tunneling layer 111 and a doped conductive layer 112 which are stacked in a direction away from the substrate.

Compared with the fact that the substrate 100 has a smooth surface, the non-metal pattern region 11 of the first surface is made lower than the metal pattern region 10 of the first surface to increase a surface area of the first surface of the substrate 100, so as to increase a contact area of the passivation contact structure 110 with the first surface of the substrate 100. In this way, in a case of keeping the passivation contact structure 110 over the non-metal pattern region 11 relatively smooth, a tunneling channel of the carriers can be enlarged and the tunneling efficiency of the carriers can be improved. Further, since the passivation contact structure 110 over the non-metal pattern region is smooth, passivation capability of the non-metal pattern region 11 of the first surface can be enhanced, and the short-circuit current and the open-circuit voltage can be increased, contributing to improve the photoelectric conversion performance of the solar cell.

Furthermore, a height difference between the non-metal pattern region 11 of the first surface and the metal pattern region 10 of the first surface forms a step structure. In addition, since the step structure is disposed at a junction between the metal pattern region 10 and the non-metal pattern region 11, the area of the passivation contact structure 110 covered on the junction can be increased. Further, since the junction is adjacent to the metal pattern region 10, the carriers in the passivation contact structure 110 at the junction can be transported to the passivation contact structure 110 over the metal pattern region 10 over a shorter distance, contributing to increase the collection capability for the carriers.

Furthermore, the non-metal pattern region 11 of the first surface is disposed lower than the metal pattern region 10 of the first surface, which is equivalent to increasing a surface area of the first surface in a height direction. Without increasing a cross sectional area of the first surface of the substrate 10, the area of the passivation contact structure 110 can be increased. Thus, when the solar cells are assembled to form a photovoltaic module, a large assembling density of the photovoltaic module can be maintained, which is favorable for maintaining a high assembly power. The height direction herein refers to a direction perpendicular to the first surface. The cross sectional area herein refers to a sectional area in a direction parallel to the first surface of the substrate 100.

It is to be noted that the height in the non-metal pattern region 11 of the first surface and the height in the metal pattern region 10 of the first surface herein both are relative to a second surface of the substrate 100. That is, the substrate has a thickness in the non-metal pattern region 11 less than a thickness in the metal pattern region 10.

The substrate 100 is configured to receive incident light and generate photo-generated carriers. In some embodiments, the substrate 100 may be a silicon substrate, and a material of the silicon substrate may include at least one of monocrystalline silicon, polycrystalline silicon, amorphous silicon or microcrystalline silicon. In some embodiments, the material of the substrate 100 may alternatively be silicon carbide, organic material or poly-compound. The poly-compound may include, but not limited to, perovskite, gallium arsenide, cadmium telluride and copper indium diselenide and the like.

In some embodiments, the solar cell is a Tunnel Oxide Passivated Contact (TOPCON) cell, the substrate 100 has a second surface opposite to the first surface, and the first surface and the second surface of the substrate 100 both may be configured to receive incident light or reflective light. In some embodiments, the substrate 100 has a doped element, and the type of the doped element is N type or P type. The N type element may be V group element such as phosphorus (P) element, bismuth (Bi) element, antimony (Sb) element, or arsenic (As) element, and the P type element may be III group element such as boron (B) element, aluminum (Al) element, gallium (Ga) element or indium (In) element. For example, when the substrate 100 is a P type substrate, the type of the doped element in the substrate is P type; or, when the substrate 100 is a N type substrate, the type of the doped element in the substrate is N type.

In some embodiments, the solar cell further includes a first electrode 130 which is electrically connected with the doped conductive layer 112.

The first electrode 130 may be in electrical contact with the doped conductive layer 112. The photo-generated carriers from the substrate 100 are transported to the doped conductive layer 112 and then transported to the first electrode 130. The first electrode 130 is configured to collect the photo-generated carriers. The first electrode 130 is disposed in the metal pattern region 10.

In some embodiments, the height difference d between the non-metal pattern region 11 of the first surface and the metal pattern region 10 of the first surface is 0.2µm to 10µm, for example, may be 0.2µm to 0.5µm, 0.5µm to 1µm, 1µm to 1.5µm, 1.5µm to 2µm, 2µm to 2.5µm, 2.5µm to 3µm, 3µm to 3.1µm, 3.1µm to 3.2µm, 3.2µm to 3.5µm, 3.5µm to 3.8µm, 3.8µm to 3.9µm, 3.9µm to 4µm, 4µm to 4.5µm, 4.5µm to 5µm, 5µm to 5.5µm, 5.5µm to 6µm, 6µm to 6.5µm, 6.5µm to 7µm, 7µm to 7.5µm, 7.5µm to 8µm, 8µm to 8.5µm, 8.5µm to 9µm or 9µm to 10µm. Within this height range, the height difference d between the non-metal pattern region 11 of the first surface and the metal pattern region 10 of the first surface can be set larger, which contributes to increase the surface area of the first surface, and further increase the area of the tunneling layer 111 in the passivation contact structure 110, thus providing a larger tunneling channel for the carriers and enhancing the transport of the carriers. On the other hand, the height difference d between the non-metal pattern region 11 of the first surface and the metal pattern region 10 of the first surface cannot be excessively large, which avoids the problem of an increased defect state density of the first surface of the substrate 100 resulting from excessive loss of the substrate 100 in an actual process of forming the height difference, thereby ensuring less carrier recombination at the first surface of the substrate 100, and contributing to increase the fill factor of the solar cell.

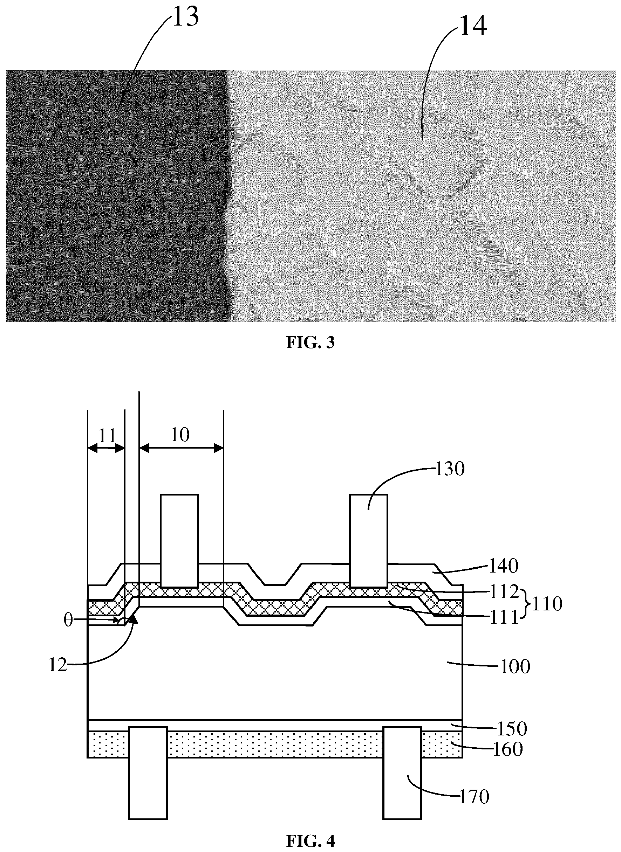

By referring to FIGS. 2 and 3, in some embodiments, the first surface has a first texture structure 13 in the metal pattern region 10, and a second texture structure 14 in the non-metal pattern region 11. The first texture structure 13 has a roughness greater than a roughness of the second texture structure 14. The roughness of the first texture structure 13 is set larger so that the surface area of the metal pattern region 10 of the first surface can be increased, and further, the passivation contact structure 110 over the metal pattern region 10 of the first surface can continue the morphology in the metal pattern region 10 of the first surface. That is, a top surface of the passivation contact structure 110 in the metal pattern region also has a larger roughness, which increases the surface area of the passivation contact structure 110, and further increases the contact area between the first electrode 130 in the passivation contact structure 110 and the passivation contact structure 110. In this way, a contact resistance of the first electrode 130 can be reduced, and the carrier transport performance can be improved.

Since the step structure is formed on the first surface of the substrate 100, the surface area of the first surface of the substrate 100 is increased in the height direction. Thus, by setting the roughness of the second texture structure 14 smaller, the surface of the non-metal pattern region 11 is made smoother. Hence, in a process of preparing the passivation contact structure 110 by a deposition process, the tunneling layer 111 and the doped conductive layer 112 deposited in the non-metal pattern region 11 of the first surface can be uniformly covered on the first surface, such that the morphologies of the tunneling layer 111 and the doped conductive layer 112 are smooth. Therefore, an interface morphology between the tunneling layer 111 and the first surface can be optimized to reduce an interface state density of the non-metal pattern region 11 of the first surface. This not only contributes to reduce recombination of the carriers at the non-metal pattern region 11 of the first surface but also can increase the tunneling capability of the carriers, thereby increasing the number of transported carriers and improving the photoelectric conversion performance of the solar cell.

In some embodiments, the first texture structure 13 includes a pyramid structure. The second texture structure 14 includes a platform embossed structure. In some embodiments, a height h1 of the pyramid structure is greater than a height h2 of the platform embossed structure, and an one-dimensional size L1 of a bottom surface of the pyramid structure is less than an one-dimensional size L2 of a bottom surface of the platform embossed structure.

The pyramid structure has a large specific surface area. The pyramid structure is included in the first texture structure, so as to further increase the surface area of the passivation contact structure 110 located in the metal pattern region 10 and further increase the contact area of the passivation contact structure 110 with the first electrode, and reduce a contact resistance.

In some embodiments, the pyramid structure may be a tetrahedron, an approximate tetrahedron, pentahedron or an approximate pentahedron or the like. The platform embossed structure is a base portion of the pyramid structure, namely, a remaining bottom structure obtained by removing a pyramid tip from the pyramid structure. In some embodiments, the second texture structure 14 may also be a platform-like embossed structure, a top surface of which may be a plane or an inclined surface and a bottom surface may be a polygonal plane, for example, may be a quadrilateral plane or a pentagonal plane.

In some embodiments, the height h1 of the pyramid structure is 0.1µm to 5µm, for example, may be 0.1µm to 0.2µm, 0.2µm to 0.5µm, 0.5µm to 1µm, 1µm to 1.5µm, 1.5µm to 2µm, 2µm to 2.5µm, 2.5µm to 3µm, 3µm to 3.5µm, 3.5µm to 4µm, 4µm to 4.5µm or 4.5µm to 5µm. In some embodiments, the one-dimensional size L1 of the bottom surface of the pyramid structure is 0.01µm to 6µm, for example, may be 0.01µm to 0.05µm, 0.05µm to 0.08µm, 0.08µm to 0.1µm, 0.1µm to 0.2µm, 0.2µm to 0.5µm, 0.5µm to 1µm, 1µm to 1.5µm, 1.5µm to 2µm, 2µm to 2.5µm, 2.5µm to 3µm, 3µm to 3.5µm, 3.5µm to 4µm, 4µm to 4.5µm, 4.5µm to 5µm, 5µm to 5.5µm or 5.5µm to 6µm. Within the ranges, the height of the pyramid structure can be set larger and the one-dimensional size of the bottom surface of the pyramid structure can be set smaller, such that the surface area of the pyramid structure can be increased so as to ensure a larger area of the passivation contact structure 110 over the metal pattern region 10 of the first surface, reduce a contact resistance between the first electrode 130 and the passivation contact structure 110, and improve the collection capability of the first electrode 130 for the carriers. Further, within the ranges, the height of the pyramid structure cannot be excessively large and the one-dimensional size of the bottom surface of the pyramid structure cannot be excessively small, so that the following problem can be avoided: the passivation contact structure 110 deposited in the metal pattern region 10 of the first surface has a lower smoothness due to excessively large roughness of the first texture structure 13, which further leads to poor surface passivation capability of the passivation contact structure 110 in the metal pattern region 10.

The one-dimensional size of the bottom surface of the pyramid structure refers to an average value by performing averaging on the one-dimensional sizes of the bottom surfaces of the pyramid structures in a randomly-designated zone within the metal pattern region 10. The height of the pyramid structure refers to an average value obtained by performing averaging on the heights of the pyramid structures in a randomly-designated zone within the metal pattern region 10.

In some embodiments, the height h2 of the platform embossed structure is 0.002µm to 1µm, for example, may be 0.002µm to 0.01µm, 0.01µm to 0.05µm, 0.05µm to 0.08µm, 0.08µm to 0.1µm, 0.1µm to 0.2µm, 0.2µm to 0.3µm, 0.3µm to 0.4µm, 0.4µm to 0.5µm, 0.5µm to 0.6µm, 0.6µm to 0.7µm, 0.7µm to 0.8µm, 0.8µm to 0.9µm or 0.9µm to 1µm. In some embodiments, the one-dimensional size L2 of the bottom surface of the platform embossed structure is 0.01µm to 1000µm, for example, may be 0.01µm to 0.05µm, 0.05µm to 0.08µm, 0.08µm to 0.1µm, 0.1µm to 0.3µm, 0.3µm to 0.5µm, 0.5µm to 0.7µm, 0.7µm to 0.9µm, 0.9µm to 1µm, 1µm to 1.2µm, 1.2µm to 10µm, 10µm to 100µm, 100µm to 150µm, 150µm to 200µm, 200µm to 350µm, 350µm to 500µm, 500µm to 650µm, 650µm to 800µm, 800µm to 900µm or 900µm to 1000µm. Within the ranges, the height of the platform embossed structure can be set smaller and the one-dimensional size of the bottom surface of the platform embossed structure can be set larger, so that the unevenness of the platform embossed structure can be smaller, and the roughness of the second texture structure 14 can be smaller. Thus, the non-metal pattern region 11 of the first surface can be smoother, which can improve a smoothness of the passivation contact structure 110 covered on the non-metal pattern region 11, and further improve surface passivation of the passivation contact structure 110 over the non-metal pattern region 11 of the first surface.

The one-dimensional size of the bottom surface of the platform embossed structure refers to an average value obtained by performing averaging on the one-dimensional sizes of the bottom surfaces of the platform embossed structures in a randomly-designated zone within the non-metal pattern region 11. The height of the platform embossed structure refers to a mean value obtained by performing averaging on the heights of the platform embossed structures in a randomly-designated zone within the non-metal pattern region 11.

By referring to FIG. 4, in some embodiments, the first surface includes a transitional region 12 adjacent to the metal pattern region 10 and the non-metal pattern region 11. A height of the transitional region 12 is not lower than the height in the non-metal pattern region 11 and not higher than the height in the metal pattern region 10. The passivation contact structure 110 is covered on the transitional region 12. The transitional region 12 adjoins both the metal pattern region 10 and the non-metal pattern region 11 respectively. The metal pattern region 10, the non-metal pattern region 11 and the transitional region 12 form a step structure. Due to presence of the transitional region 12, the area of the first surface is increased so as to increase the area of the passivation contact structure 110 on the first surface, thereby providing a larger tunneling channel and transport channel for the carriers and improving the carrier transport capability.

Since the transitional region 12 is disposed adjacent to the metal pattern region 10, when the passivation contact structure 110 is covered on the transitional region 12, the passivation contact structure 110 on the transitional region 12 is also adjacent to the metal pattern region 10. Hence, the carriers in the passivation contact structure 110 on the transitional region 12 can be transported to the first electrode 130 over a shorter distance, thereby reducing the transport loss and improving the number of transported carriers.

In some embodiments, the transitional region is disposed inclined relative to the non-metal pattern region, such that the passivation contact structure 110 covered on the transitional region 12 is inclined relative to the passivation contact structure 110 in the non-metal pattern region. Compared with increasing the surface area of the non-metal pattern region of the first surface by increasing the roughness of the non-metal pattern region of the first surface to increase the surface area of the passivation contact structure 110, increasing the area of the passivation contact structure 110 by disposing the step structure on the first surface of the substrate 100 is more conducive to improving the carrier transport efficiency. The reason is that, if the roughness of the non-metal pattern region of the first surface is increased, the part of the increased area of the passivation contact structure 110 is still located in the non-metal pattern region of the first surface, and the transport distance of the carriers between the passivation contact structure 110 and the first electrode 130 is not shortened. Since the transitional region 12 is adjacent to the metal pattern region, the carriers in the passivation contact structure 110 covered on the transitional region 12 can be transported to the first electrode 130 over a shorter distance, thus reducing the transport loss and improving the carrier transport efficiency.

In some embodiments, the transitional region 12 may be perpendicular to both the metal pattern region 10 of the first surface and the non-metal pattern region 11 of the first surface.

In some embodiments, the transitional region 12 may alternatively be inclined relative to the non-metal pattern region 11 and the metal pattern region 10. Hence, in a case of keeping the height difference between the non-metal pattern region 11 and the metal pattern region 10 unchanged, as compared with the fact that the transitional region 12 is perpendicular to the metal pattern region 10 and the non-metal pattern region 11, the area of the passivation contact structure 110 on the transitional region 12 is increased, which provides a larger tunneling channel and transport channel for the carriers.

Based on the above considerations, in some embodiments, there is an included angle between the non-metal pattern region 11 and the transitional region 12. The included angle θ is in a range of 90° to 160°, for example, may be 90° to 95°, 95° to 100°, 100° to 105°, 105° to 110°, 110° to 115°, 115° to 120°, 120° to 125°, 125° to 130°, 130° to 135°, 135° to 140°, 140° to 145°, 145° to 150°, 150° to 155° or 155° to 160°. Within this range, the transitional region can be inclined relative to the non-metal pattern region 11 such that the transitional region 12 has a larger surface area, which increases the area of the passivation contact structure 110 on the transitional region 12, thereby providing a larger tunneling channel for the carriers and increasing the carrier tunneling probability.

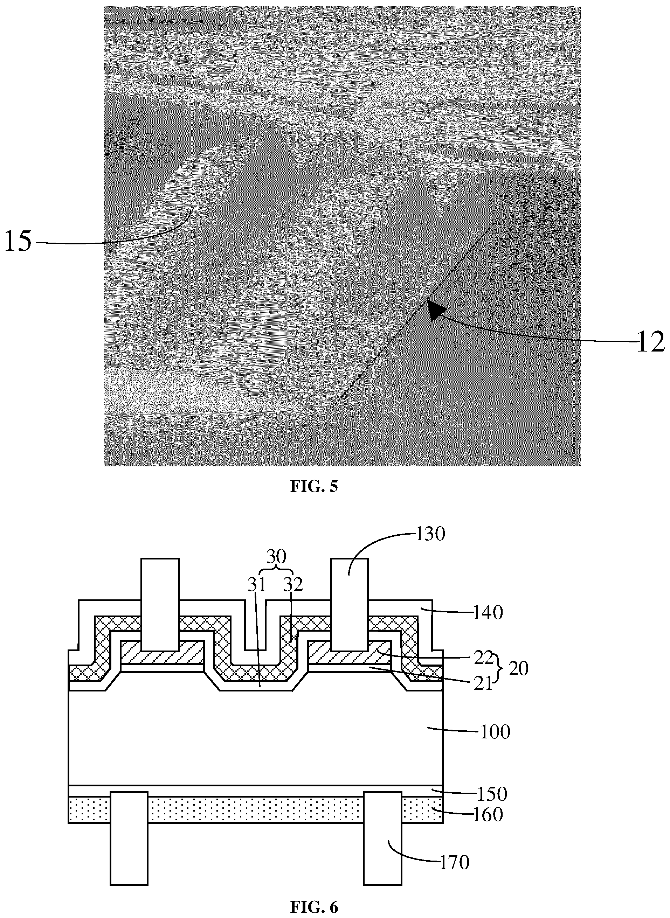

By referring to FIG. 5, in some embodiments, the transitional region has a third texture structure 15, which has a roughness less than the roughness of the first texture structure 13. By disposing the third texture structure 15 on the transitional region 12, the surface area of the transitional region 12 can be further increased so as to increase the area of the passivation contact structure 110 on the transitional region 12.

In some embodiments, the third texture structure includes a plurality of triangular-prism-shaped embossed structures adjacent to each other, each of the plurality of triangular-prism-shaped embossed structures has a sectional shape of triangular or triangle-like in a direction perpendicular to the transitional region 12. There are three edges on sides of each of the plurality of triangular-prism-shaped embossed structures, where two edges are located on the transitional region 12 and the remaining one protrudes out of the transitional region 12. The plurality of triangular-prism-shaped embossed structures stretch across the transitional region 12 in a direction pointing from the non-metal pattern region 11 to the metal pattern region 10. In this way, the surface area of the third texture structure 15 is increased. It may be easily found that the sides of the triangular-prism-shaped embossed structures form the transitional region 12. The sides of the triangular-prism-shaped embossed structures are smooth and across the transitional region 12, such that the passivation contact structure 110 deposited on the transitional region 12 is smooth, which is conducive to the tunneling of the carriers. Further, the third texture structure 15 disposed on the transitional region 12 can further increase the area of the passivation contact structure 110.

The doped conductive layer 112 has the effect of field passivation, such that minority carriers escape from an interface so as to reduce a concentration of the minority carriers. Thus, the carrier recombination rate at the interface of the substrate 100 can be reduced, and an open circuit voltage, a short circuit current and a fill factor of the solar cell can be increased, thereby improving the photoelectric conversion performance of the solar cell.

The tunneling layer 111 is configured to perform interface passivation on the first surface to achieve the effect of chemical passivation. Specifically, by using dangling bonds of the saturated first surface, an interface defect state density of the first surface can be decreased so as to lessen the recombination centers of the first surface.

As shown in FIG. 6, in some embodiments, the tunneling layer includes at least one first tunneling layer 21 and at least one second tunneling layer 31. The doped conductive layer includes at least one first doped conductive layer 22 and at least one second doped conductive layer 32. The passivation contact structure includes a first passivation contact structure 20 located over the metal pattern region 10 of the first surface. The first passivation contact structure 20 includes at least one first tunneling layer 21 and at least one first doped conductive layer 22 stacked in a direction away from the substrate 100. The passivation contact structure includes a second passivation contact structure 30, including first portion and second portion adjacent to each other. The first portion covers side surfaces and a top surface of the first passivation contact structure 20, and the second portion covers the remaining first surface other than the metal pattern region 10 of the first surface. The second passivation contact structure 30 includes at least one second tunneling layer 31 and at last one second doped conductive layer 32 stacked in the direction away from the substrate 100.

The second passivation contact structure 20 covers not only the non-metal pattern region but also the transitional region 12. Thus, the second passivation contact structure 30 is a continuous film layer which can improve the transverse transport performance of the carriers in the second passivation contact structure 30, thereby contributing to transport the carriers.

In some embodiments, the first electrode 130 penetrates through the second passivation contact structure 30 to be in electrical contact with the first doped conductive layer 22 so as to collect carriers transported in the second doped conductive layer 32 and the first doped conductive layer 22.

Since the first passivation contact structure 20 and the second passivation contact structure 30 are disposed in the metal pattern region 10 of the first surface at the same time, a probability that the first electrode 130 penetrates through the first passivation contact structure 20 and the second passivation contact structure 30 to the substrate 100 can be reduced in an actual process of preparing the first electrode 130, thereby reducing generation of the carrier recombination centers.

Furthermore, since the second passivation contact structure 30 covers the first passivation contact structure 20 and the remaining surface of the first surface other than the surface covered by the first passivation contact structure, namely, the first passivation contact structure 20 does not contact incident light directly, and the probability that the first electrode 130 penetrates through to the substrate 100 can be further reduced without increasing the parasitic absorption of the first passivation contact structure 20 for incident light. Further, in order to reduce the parasitic absorption of the second passivation contact structure 30 for incident light, the thickness of the second doped conductive layer 32 may be set smaller, so as to improve the parasitic utilization rate of the substrate 100 for incident light.

That is, in the stacked first passivation contact structure 20 and second passivation contact structure 30, the second passivation contact structure 30 is configured to achieve the effect of reducing the parasitic absorption for incident light and improving transverse transport of the carriers, and the first passivation contact structure 20 is configured to reduce the probability that the metal electrode penetrates through to the substrate 100, thereby entirely improving the photoelectric conversion performance of the solar cell.

In some embodiments, the first passivation contact structure 20 may only include one first tunneling layer 21 and one first doped conductive layer 22, and the first tunneling layer 21 is in direct contact with the first surface.

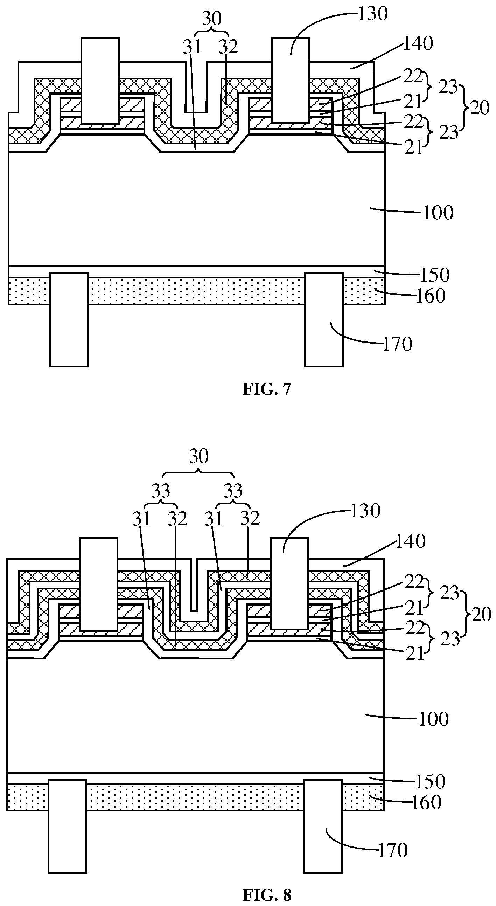

By referring to FIG. 7, in some embodiments, the first passivation contact structure 20 may alternatively include a plurality of sub-first passivation contact structures 23 sequentially stacked in a direction away from the substrate 100, and each sub-first passivation contact structure 23 includes a first tunneling layer 21 and a first doped conductive layer 22 sequentially stacked in the direction away from the substrate 100. That is, the first passivation contact structure 20 may include a plurality of first tunneling layers 21 and a plurality of first doped conductive layers 22, which are alternately stacked. FIG. 7 shows two sub-first passivation contact structures 23.

In some embodiments, the second passivation contact structure 30 may only include one second tunneling layer 31 and one second doped conductive layer 32, where the second tunneling layer 31 covers a top surface of the first passivation contact structure 20 and the non-metal pattern region 11 of the first surface. In some embodiments, when the second passivation contact structure 30 only includes one second tunneling layer 31 and one second doped conductive layer 32, the first passivation contact structure 20 may include a plurality of sub-first passivation contact structures 23 or only include one first tunneling layer 21 and one first doped conductive layer 22.

By referring to FIG. 8, in some embodiments, the second passivation contact structure 30 may include a plurality of sub-second passivation contact structures 33 sequentially stacked in a direction away from the substrate 100, and each sub-second passivation contact structure 33 includes a second tunneling layer 31 and a second doped conductive layer 32 sequentially stacked in the direction away from the substrate 100. That is, the second passivation contact structure 30 may include a plurality of second tunneling layers 31 and a plurality of second doped conductive layers 32, which are alternately stacked. FIG.8 shows two sub-second passivation contact structures 33.

By referring to FIG. 8, in some embodiments, when the second passivation contact structure 30 includes a plurality of sub-second passivation contact structures 33, the first passivation contact structure 20 may include a plurality of sub-first passivation contact structures 23.

In some embodiments, when the second passivation contact structure 30 includes a plurality of sub-second passivation contact structures 33, the first passivation contact structure 20 may only include one first tunneling layer 21 and one first doped conductive layer 22, as long as the second passivation contact structure 30 can wrap the first passivation contact structure 20.

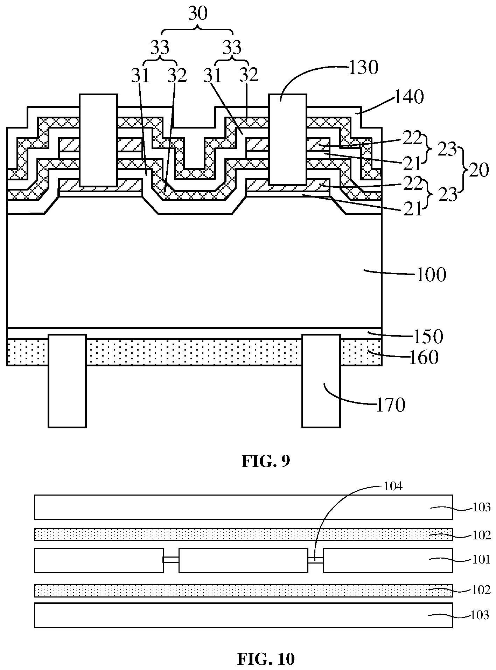

In some embodiments, a plurality of first passivation contact structures 20 and a plurality of second passivation contact structures 30 are disposed, where the plurality of first passivation contact structures 20 and the plurality of second passivation contact structures 30 are alternately stacked in a direction away from the substrate 100. Each second passivation contact structure 30 covers the top surface and the side surfaces of a respective first passivation contact structure 20, the second passivation contact structure 30 close to the substrate 100 covers the non-metal pattern region 11 of the first surface, and the remaining second passivation contact structures 30 cover the top surface of a neighboring second passivation contact structure 30. In other words, as shown in FIG. 9, two sub-first passivation contact structures 23 and two sub-second passivation contact structures 33 are alternately stacked in the direction away from the substrate 100.

Alternatively, in other words, tunneling layers and doped conductive layers included in the first and second passivation contact structures may include one layer or multiple sub-layers, as long as the first and second passivation contact structures are stacked to increase the thickness of the passivation contact structure. The detailed illustration is as follows.

In some embodiments, the first passivation contact structure 20 may only include one first tunneling layer 21 and one first doped conductive layer 22, and the second passivation contact structure 30 may only include one second tunneling layer 31 and one second doped conductive layer 32, as shown in FIG. 6.

In some embodiments, the first passivation contact structure 20 includes a plurality of sub-first passivation contact structures 23 sequentially stacked in the direction away from the substrate 100, and each of the plurality of sub-first passivation contact structures 23 includes a first tunneling sub-layer 21 and a first doped conductive sub-layer 22 sequentially stacked in the direction away from the substrate. FIG. 7 shows two sub-first passivation contact structures, and the second passivation contact structure 33 only including one second tunneling layer 31 and one second doped conductive layer 32.

In some embodiments, the first passivation contact structure 20 includes a plurality of sub-first passivation contact structures 23 sequentially stacked in the direction away from the substrate 100, and each of the plurality of sub-first passivation contact structures 23 includes a first tunneling sub-layer 21 and a first doped conductive sub-layer 22 sequentially stacked in the direction away from the substrate. The second passivation contact structure 30 includes a plurality of sub-second passivation contact structures 33 sequentially stacked in the direction away from the substrate 100, and each of the plurality of sub-second passivation contact structures 33 includes a second tunneling sub-layer 31 and a second doped conductive sub-layer 32 sequentially stacked in the direction away from the substrate. FIG. 8 shows two sub-first passivation contact structures and two sub-second passivation contact structures sequentially stacked, and FIG. 9 shows two sub-first passivation contact structures and two sub-second passivation contact structures alternately stacked.

When there are a plurality of sub-first passivation contact structures 23 and/or a plurality of sub-second passivation contact structures 33, correspondingly, there are a plurality of first tunneling sub-layers, a plurality of first doped conductive sub-layers, a plurality of second tunneling sub-layers, a plurality of second doped conductive sub-layers, respectively. In the preparing process of the solar cell, the plurality of sub-layers are considered as a whole, and the configurations for concentration of doping elements, thickness and material in the following embodiments apply to the embodiments concerning about single layer and the plurality of sub-layers.

In some embodiments, a concentration of a doped element in the first doped conductive layer 22 is greater than or equal to a concentration of a doped element in the second doped conductive layer 32. In some embodiments, the concentration of the doped element in the first doped conductive layer 22 and the concentration of the doped element in the second doped conductive layer 32 both are greater than a concentration of the doped element in the substrate 100, such that the first doped conductive layer 22 and the second doped conductive layer 32 form a heavily-doped region relative to the substrate 100. The heavily-doped region and the substrate 100 form a high-low junction which enables the carriers to generate a barrier effect. Thus, the transport rate and the number of the carriers transported from the substrate 100 to the first doped conductive layer 22 and the second doped conductive layer 32 are increased, and hence the first electrode 130 can collect the carriers effectively.

In some embodiments, the concentration of the doped element in the first doped conductive layer 22 may be greater than the concentration of the doped element in the second doped conductive layer 32. The first doped conductive layer 22 is located in the metal pattern region 10 and in electrical contact with the first electrode 130. By setting the concentration of the doped element in the first doped conductive layer 22 larger, the barrier effect of the carriers can be further enhanced, so as to increase a tunneling probability of the carriers in the substrate 100 as well as the carrier concentration of the first doped conductive layer 22, helping the first electrode 130 to collect more carriers.

The second doped conductive layer 32 covers the non-metal pattern region 11 of the first surface. By setting the concentration of the doped element in the second doped conductive layer 32 less, generation of auger recombination at the non-metal pattern region 11 of the first surface can be lessened, so as to reduce recombination of the carriers at the non-metal pattern region 11 of the first surface and improve the passivation effect on the non-metal pattern region 11 of the first surface, helping to further increase the number of the transported carriers as well as the open circuit voltage and the short circuit current.

In some embodiments, the concentration of the doped element in the first doped conductive layer 22 is in a range of 5×10¹⁸atoms/cm³ to 1×10²¹atoms/cm³, for example, may be 5×10¹⁸atoms/cm³ to 7×10¹⁸atoms/cm³, 7×10¹⁸atoms/cm³ to 9×10¹⁸atoms/cm³, 9×10¹⁸atoms/cm³ to 1×10¹⁹atoms/cm³, 1×10¹⁹atoms/cm³ to 5×10¹⁹atoms/cm³, 5×10¹⁹atoms/cm³ to 1×10²⁰atoms/cm³, 1×10²⁰atoms/cm³ to 5×10²⁰atoms/cm³or 5×10²⁰atoms/cm³ to 1×10²¹atoms/cm³. In some embodiments, the concentration of the doped element of the second doped conductive layer 32 is 5×10¹⁸atoms/cm³ to 9×10²⁰atoms/cm³, for example, may be 5×10¹⁸atoms/cm³ to 7×10¹⁸atoms/cm³, 7×10¹⁸atoms/cm³ to 1×10¹⁹atoms/cm³, 1×10¹⁹atoms/cm³ to 5×10¹⁹atoms/cm³, 5×10¹⁹atoms/cm³ to 9×10¹⁹atoms/cm³, 9×10¹⁹atoms/cm³ to 1×10²⁰atoms/cm³, 1×10²⁰atoms/cm³ to 5×10²⁰atoms/cm³ or 5×10²⁰atoms/cm³ to 9×10²⁰atoms/cm³. Within the above range, the concentration of the doped element in the first doped conductive layer 22 may be set to larger to increase the tunneling capability of the carriers in the substrate 100 corresponding to the metal pattern region 10, and improve the collection capability of the first electrode 130 for the carriers. Further, the concentration of the doped element in the second doped conductive layer 32 may be set to be within the above range, such that the doping concentration of the second doped conductive layer 32 is smaller, which ensures the surface passivation capability of the second doped conductive layer 32 on the non-metal pattern region 11 of the first surface.

In some embodiments, the concentration of the doped element in the first doped conductive layer 22 may be equal to the concentration of the doped element in the second doped conductive layer 32.

In some embodiments, a thickness of the first doped conductive layer 22 is greater than or equal to a thickness of the second doped conductive layer 32. In some embodiments, the thickness of the first doped conductive layer 22 is greater than the thickness of the second doped conductive layer 32. By setting the thickness of the first doped conductive layer 22 larger, the probability that the first electrode 130 penetrates through to the substrate 100 can be reduced, and the contact area of the first doped conductive layer 22 with the first electrode 130 can be increased. Thus, the contact resistance can be reduced, and the transport loss of transporting the carriers to the first electrode 130 can be diminished, contributing to enhance the collection capability of the first electrode 130 for the carriers. By setting the thickness of the second doped conductive layer 32 smaller, the parasitic absorption of the second doped conductive layer 32 for incident light can be reduced, and the absorption utilization rate of the substrate 100 for incident light can be improved, thereby improving the photoelectric conversion performance.

In some embodiments, the thickness of the first doped conductive layer 22 is in a range of 5nm to 500nm, for example, may be 5nm to 10nm, 10nm to 50nm, 50nm to 80nm, 80nm to 100nm, 100nm to 150nm, 150nm to 200nm, 200nm to 250nm, 250nm to 300nm, 300nm to 350nm, 350nm to 400nm, 400nm to 450nm or 450nm to 500nm. In some embodiments, the thickness of the second doped conductive layer 32 is in a range of 1nm to 200nm, for example, may be 1nm to 5nm, 5nm to 10nm, 10nm to 30nm, 30nm to 50nm, 50nm to 80nm, 80nm to 100nm, 100nm to 130nm, 130nm to 150nm, 150nm to 170nm, 170nm to 185nm or 185nm to 200nm. Within the above range, the thickness of the first doped conductive layer 22 may be set larger, which can effectively reduce the probability that the first electrode 130 penetrates through the first doped conductive layer 22. Within the above range, the thickness of the second doped conductive layer 32 may be set smaller, which can reduce the parasitic absorption of the second doped conductive layer 32 for incident light. In this way, the absorptivity of the substrate 100 for incident light can be improved.

In some embodiments, the thickness of the first doped conductive layer 22 may be equal to the thickness of the second doped conductive layer 32.

In some embodiments, a material of the first doped conductive layer 22 includes at least one of amorphous silicon, polycrystalline silicon, and silicon carbide, and a material of the second doped conductive layer 32 includes at least one of amorphous silicon, polycrystalline silicon, and silicon carbide. In some embodiments, the material of the first doped conductive layer 22 may be same as the material of the second doped conductive layer 32. In some embodiments, the material of the first doped conductive layer 22 may alternatively be different from the material of the second doped conductive layer 32.

In some embodiments, a thickness of the first tunneling layer 21 may be less than or equal to a thickness of the second tunneling layer 31. In some embodiments, the thickness of the first tunneling layer 21 may be less than the thickness of the second tunneling layer 31. The first tunneling layer 21 is in direct contact with the first surface at the metal pattern region 10 to achieve tunneling of majority carriers and selective transport of the carriers. Due to the smaller thickness of the first tunneling layer 21, the carriers in the substrate 100 corresponding to the metal pattern region 10 can more easily pass through the first tunneling layer 21, thereby increasing the tunneling probability of the carriers and further increasing the transport efficiency of the carriers. Furthermore, since the first tunneling layer 21 has a smaller thickness, when the first tunnel layer 21 is deposited actually, the first tunneling layer 21 obtained by depositing has a high uniformity, which can improve a contact section morphology between the first tunneling layer 21 and the first surface, facilitating the tunneling of the carriers.

The thickness of the second tunneling layer 31 is set larger, which makes it difficult for the conductive paste for forming the first electrode 130 to burn through the second tunneling layer 31 during the process of preparing the first electrode 130. In this way, the probability that the first electrode 130 penetrates through to the substrate 100 can be further reduced, and the generation of the carrier recombination centers can be lessened.

In some embodiments, the thickness of the first tunneling layer 21 is in a range of 0.1nm to 5nm, for example, may be 0.1nm to 0.5nm, 0.5nm to 0.8nm, 0.8nm to 1nm, 1nm to 1.5nm, 1.5nm to 2nm, 2nm to 2.5nm, 2.5nm to 3nm, 3nm to 3.5nm, 3.5nm to 4nm, 4nm to 4.5nm or 4.5nm to 5nm; the thickness of the second tunneling layer 31 is in a range of 0.2nm to 10nm, for example, may be 0.2nm to 0.5nm, 0.5nm to 0.8nm, 0.8nm to 1.2nm, 1.2nm to 2nm, 2nm to 2.5nm, 2.5nm to 3nm, 3nm to 3.5nm, 3.5nm to 4nm, 4nm to 4.5nm, 4.5nm to 5nm, 5nm to 6nm, 6nm to 7nm, 7nm to 8nm, 8nm to 9nm or 9nm to 10nm. Within the above range, on one hand, the thickness of the first tunneling layer 21 may be set smaller, which contributes to enhance the tunneling of the carriers in the substrate 100 corresponding to the metal pattern region 10; further, within the above range, the thickness of the first tunneling layer 21 cannot be excessively small, which can prevent the problem of formation of cavities in a deposition process due to small thickness.

Within the above range, the thickness of the second tunneling layer 31 may be set larger, and the probability that the first electrode 130 burns through to the substrate 100 can be reduced by adjusting the thickness of the second tunneling layer 31 to be larger.

In some embodiments, the thickness of the first tunneling layer 21 may be same as the thickness of the second tunneling layer 31.

In some embodiments, the material of the first tunneling layer 21 is different from the material of the second tunneling layer 31. By making the materials of the first tunneling layer 21 and the second tunneling layer 31 different, the respective functions of the first tunneling layer 21 and the second tunneling layer 31 can be enhanced. For example, the tunneling effect of the first tunneling layer 21 for the carriers can be enhanced and the blocking effect of the second tunneling layer 31 for the turning-through of the first electrode 130 can be enhanced.

In some embodiments, the material of the first tunneling layer 21 includes at least one of silicon oxide, aluminum oxide, silicon nitride, silicon oxynitride, amorphous silicon or polycrystalline silicon. In some embodiments, the material of the second tunneling layer 31 includes at least one of silicon oxide, aluminum oxide, silicon nitride, silicon oxynitride, amorphous silicon or polycrystalline silicon.

In some embodiments, a pinhole density of the material of the first tunneling layer 21 is less than a pinhole density of the material of the second tunneling layer 31. Due to smaller pinhole density of the material of the first tunneling layer 21, the probability that the carriers pass through the first tunneling layer 21 can be increased. Due to the larger pinhole density of the material of the second tunneling layer 31, the burning-through capability of the conductive paste for preparing the first electrode 130 can be further reduced, and the probability that the first electrode 130 penetrates the first passivation contact structure 20 can be decreased, and the defect state density of the second tunneling layer 31 can be reduced, and thus the passivation performance of the second tunneling layer 31 for the non-metal pattern region 11 of the first surface can be improved. In view of this, in some embodiments, the material of the first tunneling layer 21 may be silicon nitride and the material of the second tunneling layer 31 may be silicon oxide.

In some embodiments, the solar cell further includes a first passivation layer 140 which is located on a surface of the second passivation contact structure 30 away from the substrate 100. The first passivation layer 140 can achieve passivation effect on the first surface, for example, achieve good chemical passivation on dangling bonds of the first surface, so as to reduce a defect state density of the first surface and suppress the carrier recombination at the first surface.

In some embodiments, the first passivation layer 140 may be a single-layer structure. In some embodiments, the first passivation layer 140 may a be multi-layer structure. In some embodiments, a material of the first passivation layer 140 may be at least one of silicon oxide, aluminum oxide, silicon nitride, or silicon oxynitride.

In some embodiments, the first electrode 130 may penetrate through the first passivation layer 140 and the second passivation contact structure 30 to be in electrical contact with the first doped conductive layer 22.

In some embodiments, the solar cell further includes an emitter 150 which is located on the second surface of the substrate 100. The emitter 150 is contrary to the substrate 100 in the type of doped element and forms a PN junction with the substrate 100. In some embodiments, a material of the emitter 150 may be same as the material of the substrate 100.

In some embodiments, the solar cell further includes a second passivation layer 160, which is located on a surface of the emitter 150 away from the substrate 100. The second passivation layer 160 is configured to achieve good passivation effect on the second surface of the substrate 100, reduce the defect state density of the second surface and suppress the carrier recombination at the back surface of the substrate 100 well. The second passivation layer 160 can also achieve good anti-reflection effect, contributing to reduce reflection of incident light and improve the utilization rate of incident light.

In some embodiments, the second passivation layer 160 may be a single-layer structure. In some embodiments, the second passivation layer 160 may also be a multi-layer structure. In some embodiments, a material of the second passivation layer 160 may be at least one of silicon oxide, aluminum oxide, silicon nitride, or silicon oxynitride.

In some embodiments, the solar cell further includes a second electrode 170, which is located on the second surface of the substrate 100. The second electrode 170 penetrates through the second passivation layer 160 to be in electrical contact with the emitter 150.

In the solar cell provided by the embodiments of the present disclosure, the non-metal pattern region 11 of the first surface is disposed to be lower than the metal pattern region 10 of the first surface, that is, a step structure is formed by the non-metal pattern region 11 and the metal pattern region 10. Compared with the substrate 100 surface which is a smooth surface, the step structure can increase a surface area of the first surface of the substrate 100, so as to increase a surface area of the passivation contact structure 110 covered on the first surface of the substrate. In this way, in a case of keeping the passivation contract structure 110 of the non-metal pattern region 11 relatively smooth, a tunneling channel for the carriers can be enlarged and the tunneling efficiency of the carriers can be thus increased.

According to another aspect of embodiments of the present disclosure, a photovoltaic module is provided. As shown in FIG. 10, the photovoltaic module includes a plurality of cell strings. Each of the plurality of cell strings is formed by connecting a plurality of solar cells 101, each of which is provided by the above embodiments. The photovoltaic module includes encapsulation layers 102, configured to cover surfaces of the plurality of cell strings. The photovoltaic module includes cover plates, configured to cover surfaces of the encapsulation layers 102 away from the plurality of cell strings. The plurality of solar cells are electrically connected in the form of an entire sheet or multiple split sheets, so as to form the plurality of cell strings which are electrically connected by series connection and/or parallel connection.

Specifically, in some embodiments, two neighboring cell strings in the plurality of cell strings may be electrically connected by a conductive band 104. The encapsulation layers 102 cover the first surface and the back surface of the solar cells 101. Specifically, the encapsulation layer 102 may be an organic encapsulation glue film such as an ethylene-vinyl acetate copolymer (EVA) glue film, a polyolyaltha olfin elastomer (POE) glue film, or a polyethylene terephthalate (PET) glue film or a polyvinyl butyral resin (PVB) or the like. In some embodiments, the cover plate 103 may be a glass cover plate or a plastic cover plate or a cover plate having a light transmission function. Specifically, a surface of the cover plate 103 facing toward the encapsulation layer 102 may be an uneven surface for increasing a utilization rate of incident light.

The above descriptions are made as above with preferred embodiments, but these embodiments are not intended to limit the claims. Without departing from the application idea of the present disclosure, those skilled in the art can make several possible changes and modifications. Thus, the scope of protection of the present disclosure shall be defined by the appended claims.

## Claims

1. A solar cell, comprising:
a substrate (100), having a first surface and a second surface opposite to the first surface, wherein the first surface includes a metal pattern region (10) and a non-metal pattern region (11), and wherein the first surface is uneven and has a first maximum height with respect to the second surface in the non-metal pattern region (11) and a second maximum height with respect to the second surface in the metal pattern region (10), the first maximum height being lower than the second maximum height;
at least one passivation contact structure (110, 20, 30), covering the first surface, and including a tunneling layer (111, 21, 31) and a doped conductive layer (112, 22, 32) stacked in a direction away from the substrate (100).

2. The solar cell of claim 1, wherein a height difference between the first maximum height and the second maximum height is in a range of 0.2µm to 10µm.

3. The solar cell of any one of claims 1 and 2, wherein the first surface has a first texture structure (13) in the metal pattern region (10) and a second texture structure (14) in the non-metal pattern region (11), and a roughness of the first texture structure (13) is greater than a roughness of the second texture structure (14);
optionally, wherein the first texture structure (13) includes a pyramid structure; the second texture structure (14) includes a platform embossed structure, a height (h1) of the pyramid structure is greater than a height (h2) of the platform embossed structure, and a one-dimensional size (L1) of a bottom surface of the pyramid structure is less than a one-dimensional size (L2) of a bottom surface of the platform embossed structure;
wherein the height (h1) of the pyramid structure is a height from a tip of the pyramid structure to a bottom of the pyramid structure and the height (h2) of the platform embossed structure is a height from a bottom of the platform embossed structure to a top surface of the platform embossed structure;
optionally, wherein the height (h1) of the pyramid structure is in a range of 0.1µ to 5µm, and the one-dimensional size (L1) of the bottom surface of the pyramid structure is in a range of 0.01µm to 6µm;
optionally, wherein the height (h2) of the platform embossed structure is in a range of 0.002µm to 1µm, and the one-dimensional size (L2) of the bottom surface of the platform embossed structure is in a range of 0.01µm to 1000µm.

4. The solar cell of any one of claims 1 to 3, wherein the first surface further includes a transitional region (12) adjacent to the metal pattern region (10) and the non-metal pattern region (11), the transitional region (12) has a height not lower than the first maximum height and not higher than the second maximum height, the height of the transitional region (12) is a height at any point of the transitional region (12) and relative to the second surface and
the at least one passivation contact structure (110, 20, 30) is covered on the transitional region (12);
optionally, wherein there is an included angle in a range of 90° to 160° between the transitional region (12) and the non-metal pattern region (11);
optionally, wherein the first surface has a third texture structure (15) in the transitional region (12) and the third texture structure (15) has a roughness less than the roughness of the first texture structure (13);
optionally, wherein the third texture structure (15) includes a plurality of triangular-prism-shaped embossed structures adjacent to each other, and each of the plurality of triangular-prism-shaped embossed structures has a sectional shape of triangular or triangle-like in a direction perpendicular to the transitional region (12).

5. The solar cell of any one of claims 1 to 4, wherein the at least one passivation contact structure includes:
a first passivation contact structure (20), over the metal pattern region (10), wherein the first passivation contact structure includes a first tunneling layer (21) and a first doped conductive layer (22) stacked in the direction away from the substrate (100);
a second passivation contact structure (30), including first portion and second portion adjacent to each other, wherein the first portion covers a top surface and side surfaces of the first passivation contact structure (20), the second portion covers the remaining region of the first surface other than the metal pattern region (10), and the second passivation contact structure (30) includes a second tunneling layer (31) and a second doped conductive layer (32) stacked in the direction away from the substrate (100).

6. The solar cell of claim 5, wherein the first passivation contact structure (20) includes a plurality of sub-first passivation contact structures (23) sequentially stacked in the direction away from the substrate (100), and each of the plurality of sub-first passivation contact structures (23) includes a first tunneling sub-layer and a first doped conductive sub-layer sequentially stacked in the direction away from the substrate (100).

7. The solar cell of claim 5, wherein the second passivation contact structure (30) includes a plurality of sub-second passivation contact structures (33) sequentially stacked in the direction away from the substrate (100), and each of the plurality of sub-second passivation contact structures (33) includes a second tunneling sub-layer and a second doped conductive sub-layer sequentially stacked in the direction away from the substrate (100).

8. The solar cell of claim 5, wherein the first passivation contact structure (20) includes a plurality of sub-first passivation contact structures (23) sequentially stacked in the direction away from the substrate (100), and each of the plurality of sub-first passivation contact structures (23) includes a first tunneling sub-layer and a first doped conductive sub-layer sequentially stacked in the direction away from the substrate (100);
the second passivation contact structure (30) includes a plurality of sub-second passivation contact structures (33) sequentially stacked in the direction away from the substrate (100), and each of the plurality of sub-second passivation contact structures (33) includes a second tunneling sub-layer and a second doped conductive sub-layer sequentially stacked in the direction away from the substrate (100);
wherein the plurality of sub-first passivation contact structures (23) and the plurality of sub-second passivation contact structures (33) are alternately stacked in the direction away from the substrate (100).

9. The solar cell of any one of claims 5 to 8, further comprising a first electrode (130), which is electrically connected with the first doped conductive layer (22).

10. The solar cell of any one of claims 5 to 9, wherein a concentration of a doped element in the first doped conductive layer (22) is greater than or equal to a concentration of a doped element in the second doped conductive layer (32).

11. The solar cell of any one of claims 5 to 10, wherein a thickness of the first doped conductive layer (22) is greater than or equal to a thickness of the second doped conductive layer (32).

12. The solar cell of any one of claims 5 to 11, wherein a material of the first doped conductive layer (22) includes at least one of amorphous silicon, polycrystalline silicon, and silicon carbide, and a material of the second doped conductive layer (32) includes at least one of amorphous silicon, polycrystalline silicon, and silicon carbide.

13. The solar cell of any one of claims 5 to 12, wherein a thickness of the first tunneling layer (21) is greater than or equal to a thickness of the second tunneling layer (31).

14. The solar cell of any one of claims 5 to 13, wherein a material of the first tunneling layer (21) is different from a material of the second tunneling layer (31);
optionally, wherein the material of the first tunneling layer (21) includes at least one of silicon oxide, aluminum oxide, silicon nitride, silicon oxynitride, amorphous silicon or polycrystalline silicon; and the material of the second tunneling layer (31) includes at least one of silicon oxide, aluminum oxide, silicon nitride, silicon oxynitride, amorphous silicon or polycrystalline silicon.

15. A photovoltaic module, comprising:
a plurality of cell strings, each formed by connecting a plurality of solar cells (101), each of plurality of solar cells (101) being the solar cell of any one of claims 1 to 14;
encapsulation layers (102), configured to cover surfaces of the plurality of cell strings;
cover plates (103), configured to cover surfaces of the encapsulation layers (102) away from the plurality of cell strings.
